# FASCICULE DE BREVET EUROPEEN

(11) **EP 3 087 813 B1**
(45) Date de publication et mention de la délivrance du brevet: **20.09.2017**
(21) Numéro de dépôt: 14830529.5
(22) Date de dépôt: 23.12.2014
(51) Int. Cl.: H05K 7/14, G06F 1/18

(54) **PROCEDE D'ENFICHAGE D'UNE CARTE ELECTRONIQUE DE MODULE ELECTRONIQUE DANS UN CONNECTEUR DE CHASSIS, SYSTEME ET MODULE ASSOCIES**
VERFAHREN ZUM STECKEN EINER ELEKTRISCHEN ELEKTROMODULLEITERPLATTE IN EINEN CHASSISSTECKER, ZUGEHÖRIGES SYSTEM UND ZUGEHÖRIGES MODUL
METHOD FOR PLUGGING AN ELECTRONIC MODULE ELECTRONIC BOARD INTO A CHASSIS CONNECTOR, ASSOCIATED SYSTEM AND ASSOCIATED MODULE

(30) Priorité: 23.12.2013 FR 1363372
(43) Date de publication de la demande: 02.11.2016
(73) Titulaire: BULL, 78340 Les Clayes Sous Bois (FR)
(72) Inventeur: MAGNOUX, Sébastien, F-95540 Mery Sur Oise (FR)
(74) Mandataire: Hirsch & Associés
(86) Numéro de dépôt international: PCT/EP2014/079277
(87) Numéro de publication internationale: WO 2015/097266

(56) Documents cités:
- EP-A2- 0 848 320
- EP-A2- 1 776 005
- WO-A1-03/065780
- US-A1- 2011 292 620

## Description

### DOMAINE DE L'INVENTION

L'invention concerne un procédé d'enfichage d'une carte électronique d'un module électronique dans le connecteur d'un châssis, un système d'enfichage comprenant le module électronique incluant la carte électronique à enficher et le châssis incluant le connecteur destiné à recevoir cette carte électronique, ainsi que le module électronique incluant la carte électronique apte à être enfichée selon le procédé d'enfichage de l'invention.

### CONTEXTE DE L'INVENTION

Selon un premier art antérieur, il est connu des cartes électroniques de modules électroniques, destinées à être enfichées dans des connecteurs de châssis, pour lesquelles la direction d'enfichage de la carte électronique dans le connecteur est la même que la direction d'introduction, par coulissement de type tiroir, du module électronique dans le châssis. Si ce type d'enfichage est plutôt pratique au niveau cinématique, il présente néanmoins notamment deux inconvénients.

Un premier inconvénient de ce premier art antérieur réside dans le fait que, lorsque dans le châssis d'une armoire électrique, les modules électroniques sont introduits par coulissement horizontal, ce qui est plus pratique pour l'opérateur, et les cartes électroniques sont enfichées également horizontalement dans le connecteur, des renvois de connexions électriques doivent alors être faits vers la carte mère électronique du châssis, laquelle carte mère électronique est dans le plan horizontal du châssis. Ces renvois de connexions électriques, sont souvent complexes à gérer, en particulier car, dans un renvoi de connexion électrique, toutes les pistes ne suivront pas naturellement des chemins de même longueur (entre celles plus à l'intérieur du coude et celles plus à l'extérieur du coude), d'où la nécessité d'une compensation supplémentaire des retards différents pour resynchroniser les signaux correspondant respectivement aux différentes pistes.

Un deuxième inconvénient de ce premier art antérieur réside dans le fait qu'il n'y pas de place pour disposer un système de démultiplication d'effort. Par conséquent, si la force d'enfichage requise pour enficher correctement la carte électronique dans le connecteur est importante, l'effort à réaliser par l'opérateur poussant horizontalement le module électronique dans le châssis, en phase finale d'enfichage, le sera également.

Selon un deuxième art antérieur, il est connu un module électronique introduit dans un châssis par coulissement horizontal de type tiroir. Lorsque le module électronique arrive en butée dans le châssis, l'ensemble du module électronique est dans une deuxième phase abaissé verticalement pour enficher la carte électronique du module électronique dans le connecteur du châssis. Si ce type d'enfichage permet d'éviter les renvois directionnels de connexions électriques, c'est-à-dire les renvois changeant la direction des connexions électriques qui étaient un inconvénient majeur du premier art antérieur, il présente néanmoins notamment deux inconvénients mis en évidence par l'invention.

Un premier inconvénient de ce deuxième art antérieur réside dans le fait que l'abaissement de l'ensemble du module électronique entraîne un défaut de stabilité et de précision, ce qui décale souvent les portions mâle et femelle de la carte électronique et du connecteur l'une par rapport à l'autre, amenant un enfichage difficile et aléatoire, risquant ainsi d'endommager des éléments de la carte électronique et du connecteur et rendant la tâche plus délicate pour l'opérateur.

Un deuxième inconvénient de ce deuxième art antérieur réside dans le fait que, l'ensemble du module électronique étant abaissé pour enficher la carte électronique dans le connecteur, l'effort à fournir par l'opérateur pour abaisser le module électronique correspond substantiellement à la force requise pour l'enfichage de la carte électronique dans le connecteur, laquelle force peut être élevée, en particulier très élevée pour certains types de connecteurs, entraînant alors un effort pénible voire même excessif pour l'opérateur. Cet effort va être d'autant plus pénible que les nécessités de la maintenance des modules électroniques vont amener à renouveler cet effort plus fréquemment.

### RESUME DE L'INVENTION

Le but de la présente invention est de fournir un procédé d'enfichage de carte électronique d'un module électronique dans le connecteur d'un châssis palliant au moins partiellement les inconvénients précités.

Plus particulièrement, l'invention vise à fournir un procédé d'enfichage d'une carte électronique dans le connecteur selon une direction d'enfichage qui est différente de la direction d'introduction du module électronique dans le châssis, afin d'éviter les renvois directionnels de connexions électriques, tout en proposant un procédé d'enfichage suffisamment stable et précis pour permettre un enfichage satisfaisant de la carte électronique dans le connecteur, et ceci, préférentiellement en ne requérant qu'un effort réduit de la part de l'opérateur introduisant le module électronique dans le châssis, surtout lorsque la force requise d'enfichage est importante.

A cette fin, la présente invention propose un procédé d'enfichage d'une carte électronique d'un module électronique dans le connecteur d'un châssis, un système d'enfichage comprenant le module électronique incluant la carte électronique à enficher et le châssis incluant le connecteur destiné à recevoir cette carte électronique, ainsi que le module électronique incluant la carte électronique apte à être enfichée selon le procédé d'enfichage de l'invention.

A cette fin, la présente invention propose un procédé d'enfichage, dans un connecteur d'un châssis, d'une carte électronique logée dans un boîtier d'un module électronique, comprenant: une translation rectiligne dudit module, par rapport audit châssis, selon une première direction, de manière à rentrer ledit module dans ledit châssis, une translation rectiligne de ladite carte, par rapport audit châssis, selon une deuxième direction différente de ladite première direction, de manière à enficher ladite carte dans ledit connecteur, ladite translation rectiligne, selon ladite deuxième direction, de ladite carte, par rapport audit châssis, étant également une translation rectiligne, selon ladite deuxième direction, de ladite carte, par rapport audit boîtier dudit module.

La carte électronique est avantageusement solidaire du module. La carte électronique est avantageusement fixe par rapport au module pendant la translation rectiligne selon la première direction. Le connecteur est avantageusement solidaire du châssis et avantageusement fixe par rapport au châssis. Avantageusement, le connecteur permet la connexion de la carte électronique à une carte électronique mère avantageusement solidaire du châssis et avantageusement fixe par rapport au châssis. Le boîtier du module est avantageusement à la fois, mobile en translation rectiligne selon la première direction et immobile en translation rectiligne selon la deuxième direction, par rapport au châssis. La direction de deuxième translation rectiligne est avantageusement parallèle à la direction d'enfichage de la carte électronique dans le connecteur. La portion de la carte électronique qui doit être enfichée dans le connecteur est préférentiellement une portion mâle s'enfichant dans un connecteur femelle, mais le contraire peut aussi être envisagé, c'est-à-dire une portion femelle de carte électronique s'accouplant avec un connecteur mâle du châssis.

A cette fin, la présente invention propose aussi un système d'enfichage, dans un connecteur d'un châssis, d'une carte électronique logée dans un boîtier d'un module électronique, comprenant: un système de translation rectiligne dudit module, par rapport audit châssis, selon une première direction, de manière à rentrer ledit module dans ledit châssis, un système de translation rectiligne de ladite carte, par rapport audit châssis, selon une deuxième direction différente de ladite première direction, de manière à enficher ladite carte dans ledit connecteur, ledit système de translation rectiligne, selon ladite deuxième direction, de ladite carte, par rapport audit châssis, étant également un système de translation rectiligne, selon ladite deuxième direction, de ladite carte, par rapport audit boîtier dudit module.

A cette fin, la présente invention propose également un module électronique comportant un boîtier, une carte électronique qui est logée dans ledit boîtier dudit module électronique et qui est destinée à être enfichée dans un connecteur d'un châssis, caractérisé en ce qu'il comprend aussi un système de translation rectiligne de ladite carte par rapport audit boîtier, ledit système de translation rectiligne étant disposé de manière à faciliter l'enfichage de ladite carte dans un connecteur de châssis, ledit système de translation rectiligne étant de préférence actionné par un actionneur mécanique actionnable manuellement, et de préférence un système de démultiplication d'effort reliant ledit actionneur à ladite carte de sorte à démultiplier l'effort manuel d'actionnement dudit actionneur pour augmenter la force d'enfichage.

Suivant des modes de réalisation préférés, l'invention comprend une ou plusieurs des caractéristiques suivantes qui peuvent être utilisées séparément ou en combinaison partielle entre elles ou en combinaison totale entre elles, avec tout ou partie des objets de l'invention précédemment mentionnés.

De préférence, la deuxième direction est perpendiculaire à la première direction. Ainsi, dans une armoire électrique, à la fois, les modules électroniques peuvent être introduits par coulissement horizontal, ce qui est plus pratique pour l'opérateur, et les cartes électroniques être enfichées verticalement dans le connecteur, ce qui évite les renvois de connexion électriques, souvent complexes à gérer, en particulier car, dans un renvoi de connexion électrique, toutes les pistes ne suivront pas naturellement des chemins de même longueur, d'où la nécessité d'une compensation supplémentaire des retards différents pour resynchroniser les signaux correspondant respectivement aux différentes pistes.

De préférence, lors de ladite translation selon la deuxième direction, ladite carte est guidée par ledit boîtier dudit module, ledit boîtier dudit module restant immobile en translation selon la deuxième direction par rapport au châssis. Ainsi, un enfichage plus précis et donc plus fluide, sans choc et sans forcer, peut être réalisé, de la carte électronique dans le connecteur, évitant ainsi de risquer d'endommager à la longue les connexions électriques de la carte électronique, lesquelles peuvent être sollicitées lors des opérations de maintenance lorsque les modules électroniques sont sortis et remis dans le châssis.

Dans un premier mode de réalisation préférentiel, ladite translation rectiligne selon ladite première direction de manière à rentrer ledit module dans ledit châssis est réalisée avant ladite translation rectiligne selon ladite deuxième direction de manière à enficher ladite carte dans ledit connecteur. Le découplage des deux translations rectilignes permet d'une part une mise en place plus aisée d'un système de démultiplication d'effort plus efficace sur la seule translation rectiligne selon la deuxième direction. D'autre part, ce découplage des deux translations rectilignes permet également une cinématique plus maîtrisée de la phase finale de l'enfichage de la carte électronique dans le connecteur, le mouvement de translation rectiligne selon la deuxième direction étant alors complètement parallèle à la direction d'enfichage de la carte électronique dans le connecteur.

De préférence, ladite translation rectiligne selon ladite deuxième direction de manière à enficher ladite carte dans ledit connecteur, est provoquée et entraînée par un déplacement d'un actionneur mécanique. De préférence, l'actionneur est actionné manuellement. Ainsi, le déplacement de la carte électronique pendant la phase finale de son enfichage dans le connecteur est synchronisé avec le déplacement de l'actionneur mécanique lui-même synchronisé avec le mouvement de l'opérateur qui garde un contrôle complet du processus d'enfichage, pouvant ainsi s'arrêter sans forcer dès qu'il sent une résistance anormale, évitant ainsi de détériorer la carte électronique et le connecteur. L'actionneur mécanique est par ailleurs robuste, simple et relativement peu coûteux.

De préférence, la course dudit déplacement dudit actionneur mécanique est supérieure à la course de ladite translation rectiligne selon ladite deuxième direction de manière à enficher ladite carte dans ledit connecteur, de sorte que le premier effort dudit déplacement dudit actionneur mécanique soit plus faible que le deuxième effort de ladite translation rectiligne selon ladite deuxième direction de manière à enficher ladite carte dans ledit connecteur, un système de démultiplication d'effort reliant ledit actionneur à ladite carte, de préférence de sorte que ledit premier effort soit au moins deux fois plus faible que ledit deuxième effort, de préférence de sorte que ledit premier effort soit au moins cinq fois plus faible que ledit deuxième effort. Ce système de démultiplication d'effort reliant ledit actionneur à ladite carte permet de réaliser un enfichage nécessitant intrinsèquement un effort conséquent, provenant de la force relativement élevée qui doit être exercée pour enficher la carte électronique dans le connecteur, par l'intermédiaire d'un effort plus modéré de l'opérateur réalisant l'enfichage, cet enfichage demeurant toutefois complètement maîtrisé par l'opérateur, grâce à la synchronisation entre son mouvement et celui de la carte électronique s'enfichant dans le connecteur.

De préférence, l'actionneur est un levier mobile en rotation. L'actionneur mobile en rotation permet à la fois une bonne démultiplication d'effort de cette rotation vers la translation selon la deuxième direction, notamment grâce au bras de levier, et un encombrement réduit du volume de déplacement de l'actionneur mobile en rotation. Un actionneur mobile en translation est également envisageable, mais soit la démultiplication d'effort sera moins importante à encombrement égal, soit l'encombrement sera plus important à démultiplication d'effort égale. Il est ici particulièrement intéressant de réduire l'encombrement du déplacement de l'actionneur mobile, car celui-ci devant être accessible à l'opérateur est situé côté extérieur du châssis, là où pour des raisons de sécurité, il vaut mieux dépasser le moins possible du plan de la façade du châssis.

De préférence, ledit système de démultiplication d'effort inclut un système à crémaillère. Ce système à crémaillère permet une démultiplication d'effort robuste, ce qui est intéressant car cette démultiplication d'effort peut être assez importante, par exemple d'un facteur 5 ou 10, dans un volume d'encombrement réduit pour le système à crémaillère, en particulier grâce à son épaisseur faible qui lui permet de se superposer aisément à la carte électronique dans le module électronique.

De préférence, ledit système à crémaillère inclut une tige mobile selon la première direction, au moins une tige mobile selon la deuxième direction, de préférence deux tiges mobiles selon la deuxième direction, et au moins une roue dentée reliant la tige mobile selon la première direction à une tige mobile selon la deuxième direction, de manière à transmettre le mouvement de la tige mobile selon la première direction à au moins une tige mobile selon la deuxième direction. Ce système à crémaillère présente une surface non négligeable, mais par contre une faible épaisseur laquelle permet de le superposer aisément au plan moyen de la carte électronique dans le module électronique.

De préférence, un système de verrouillage est disposé de manière à n'autoriser ladite translation selon la deuxième direction qu'après la fin de ladite translation selon la première direction. Ce système de verrouillage offre une sécurité supplémentaire intéressante car elle empêche de débuter prématurément la translation rectiligne selon la deuxième direction avant que le module électronique ne soit à la bonne position dans le châssis, là où aucun élément protubérant ne gêne la translation rectiligne selon la deuxième direction, évitant ainsi des chocs entre des parties du module électronique et des parties du châssis, lesquels chocs risqueraient de dégrader certaines parties du module électronique et / ou du châssis.

Dans un deuxième mode de réalisation optionnel, ladite translation rectiligne selon ladite première direction de manière à rentrer ledit module dans ledit châssis est réalisée simultanément à ladite translation rectiligne selon ladite deuxième direction de manière à enficher ladite carte dans ledit connecteur. L'ensemble du dispositif d'enfichage est plus simple mécaniquement que pour le premier mode de réalisation, mais d'une part la démultiplication d'effort est moins efficace, et d'autre part l'encombrement, notamment à l'extérieur de la façade du châssis, peut être plus important.

De préférence, la première course de ladite translation rectiligne selon ladite première direction de manière à rentrer ledit module dans ledit châssis est plus longue que la deuxième course de ladite translation rectiligne selon ladite deuxième direction de manière à enficher ladite carte dans ledit connecteur, de sorte que le premier effort de ladite translation rectiligne selon ladite première direction de manière à rentrer ledit module dans ledit châssis soit plus faible que le deuxième effort de ladite translation rectiligne selon ladite deuxième direction de manière à enficher ladite carte dans ledit connecteur, ladite première course étant de préférence au moins deux fois plus longue que ladite deuxième course. Ainsi la démultiplication d'effort est réalisée, même si elle est moins importante que pour le premier mode de réalisation.

De préférence, le mouvement relatif entre ladite carte et ledit boîtier dudit module est réalisé par l'intermédiaire d'au moins un ensemble d'un pion glissant dans une lumière rectiligne, la direction de ladite lumière rectiligne étant plus proche de la première direction que de la deuxième direction. Ce système pion glissant dans une lumière rectiligne est particulièrement simple mécaniquement.

Pour les deux modes de réalisation, certaines autres caractéristiques préférentielles, combinables avec les précédentes ou utilisables seules, sont maintenant données.

Préférentiellement, la translation selon la première direction s'effectue horizontalement par rapport au châssis immobile par rapport au sol, et la deuxième translation s'effectue verticalement par rapport à ce châssis.

Préférentiellement, le système de démultiplication d'effort permet à l'utilisateur de fournir un effort au moins 2 fois moindre, ou au moins 5 fois moindre, ou au moins 10 fois moindre que la force requise d'enfichage de la carte électronique dans le connecteur. Préférentiellement, la force d'enfichage requise est comprise entre 10 kg et 50 kg, et encore plus de préférence entre 20 et 30 kg. Préférentiellement, la plage d'effort à fournir par l'opérateur est comprise entre 1 et 5 kg, et encore plus de préférence entre 3 et 4 kg.

Préférentiellement, un système de verrouillage est disposé de manière d'une part à bloquer l'actionneur mécanique en position lorsque la carte électronique est enfichée dans le connecteur, et avantageusement d'autre part à n'autoriser la libération de l'actionneur mécanique que par un autre geste spécifique de l'opérateur distinct du geste de déplacement de l'actionneur mécanique.

D'autres caractéristiques et avantages de l'invention apparaîtront à la lecture de la description qui suit d'un mode de réalisation préféré de l'invention, donnée à titre d'exemple et en référence aux dessins annexés.

### BREVE DESCRIPTION DES DESSINS

La figure 1 représente schématiquement un exemple de module électronique selon un mode de réalisation de l'invention.
La figure 2 représente schématiquement un exemple de module électronique coulissant dans un châssis d'armoire électrique à la manière d'un tiroir selon un mode de réalisation de l'invention.
La figure 3 représente schématiquement un exemple d'une première phase de coulissement horizontal d'un module électronique coulissant dans un châssis d'armoire électrique selon un mode de réalisation de l'invention.
La figure 4 représente schématiquement un exemple d'une deuxième phase d'enfichage vertical de la carte électronique d'un module électronique dans le connecteur d'un châssis d'armoire électrique selon un mode de réalisation de l'invention.
La figure 5 représente schématiquement un exemple d'une phase d'extraction verticale de la carte électronique d'un module électronique hors du connecteur d'un châssis d'armoire électrique selon un mode de réalisation de l'invention.
La figure 6 représente schématiquement une vue de côté d'un exemple de boîtier d'un module électronique selon un premier mode de réalisation de l'invention, un peu avant la fin de la phase de translation horizontale.
La figure 7 représente schématiquement une vue en perspective d'un exemple de boîtier d'un module électronique selon un premier mode de réalisation de l'invention, un peu avant la fin de la phase de translation horizontale.
La figure 8 représente schématiquement une vue en perspective d'un exemple de boîtier d'un module électronique selon un premier mode de réalisation de l'invention, à la fin de la phase de translation horizontale.
La figure 9 représente schématiquement un détail du système de verrouillage bloquant la translation verticale d'enfichage pour un module électronique selon un premier mode de réalisation de l'invention.
La figure 10 représente schématiquement une vue de côté d'un exemple de module électronique selon une première variante d'un deuxième mode de réalisation de l'invention.
La figure 11 représente schématiquement une vue de côté d'un exemple de module électronique selon une deuxième variante d'un deuxième mode de réalisation de l'invention.

### DESCRIPTION DETAILLEE DE L'INVENTION

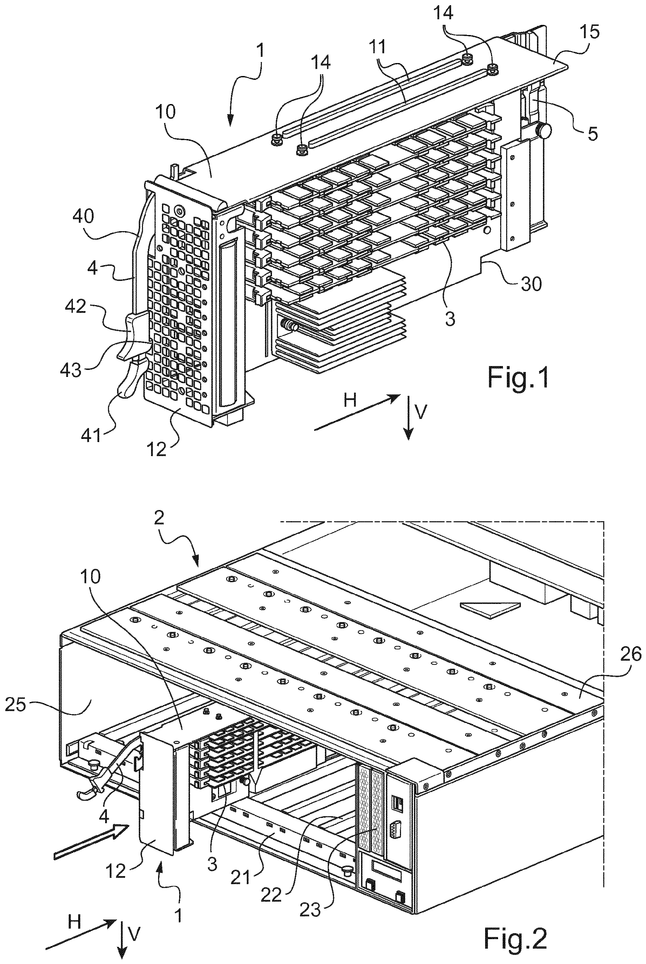

Dans l'ensemble des figures 1 à 11, les sens horizontal et vertical, représentés par des flèches H et V, sont donnés par rapport au châssis d'une armoire électrique installée sur le sol. Le sens de la flèche H représente le sens de la translation dans une première direction qui est une translation horizontale, tandis que la flèche V représente le sens de la translation dans une deuxième direction, perpendiculaire à la première direction, qui est une translation verticale.

La figure 1 représente schématiquement un exemple de module électronique selon un mode de réalisation de l'invention. Un module électronique 1 comporte un boîtier 10 dans lequel est logée une carte électronique 3. La carte électronique 3 comprend, en partie basse, une portion mâle 30 enfichable dans un connecteur femelle appartenant à la carte mère électronique d'un châssis. La carte électronique 3 est mobile en translation verticale par rapport au boîtier 10. La translation verticale de la carte électronique 3 n'est autorisée que lorsqu'un système de verrouillage 5 fixé sur le boîtier 10 est déverrouillé.

Le boîtier 10 comprend sur sa face supérieure 15 des rails horizontaux 11 et des pions de guidage 14 qui sont situés dans l'axe des rails de guidage 11 et dans le prolongement des rails de guidage 11. La face du boîtier destinée à être dans le plan de la façade du châssis est une grille 12 percée de trous permettant l'aération de l'intérieur du module électronique 1 et du reste du châssis électronique.

La translation verticale de la carte électronique 3 est provoquée et entraînée par la rotation d'un actionneur 4 mobile en rotation. Cet actionneur 4 est un levier mobile en rotation. Ce levier 4 comprend un point de pivotement non visible sur la figure 1, un bras 40 au bout duquel se situe la poignée d'actionnement 41 sur laquelle appuie l'opérateur pour faire pivoter le levier 4.

En position verticale, correspondant à la carte électronique 3 enfichée dans le connecteur, le levier 4 est solidarisé à la grille 12 par l'intermédiaire d'un ergot 43 qui vient s'encliqueter dans l'un des trous de la grille 12. Pour libérer l'ergot 43 de la grille 12, et donc pour permettre au levier 4 de pivoter vers le haut, il faut abaisser la pièce élastique 42 dont est solidaire l'ergot 43, cette pièce élastique étant naturellement maintenue vers le haut par un élément de type ressort.

La figure 2 représente schématiquement un exemple de module électronique coulissant dans un châssis d'armoire électrique à la manière d'un tiroir selon un mode de réalisation de l'invention. Un châssis 2 comprend un logement 25 entouré par plusieurs parois, par un capot 26 et par une façade 23 ouverte sur l'extérieur du châssis 2. L'ouverture de la façade 23 comprend un rebord 21 de protection dans sa partie basse. Au fond du logement 25 est disposée une carte mère électronique 22. Par l'intermédiaire de ses rails 11 de guidage qui coulissent dans des rainures du capot 26 du châssis 2, le module électronique 1 est introduit dans le logement 25 du châssis 2 par une translation horizontale vers l'intérieur du châssis, c'est-à-dire vers la droite dans la figure 2. Le levier 4 est en position relevée.

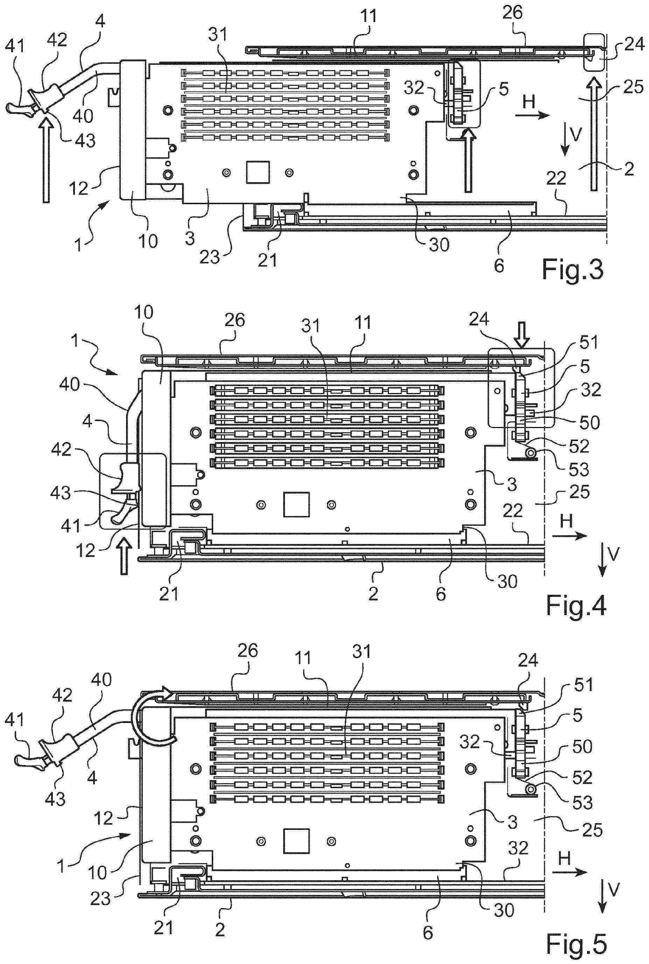

La figure 3 représente schématiquement un exemple d'une première phase de coulissement horizontal d'un module électronique coulissant dans un châssis d'armoire électrique selon un mode de réalisation de l'invention. La carte électronique 3 comporte des composants électroniques 31, par exemple de type mémoires ou autres, dont les pistes vont devoir être connectées aux pistes des composants électroniques de la carte mère électronique 22. La carte électronique 3 est associée à une protubérance 32 qui reste bloquée par le système de verrouillage 5 en position verrouillée, bloquant ainsi en position relevée le levier 4 et empêchant la translation verticale vers le bas de la carte électronique 3 par rapport au reste du boîtier 10. En effet, tant que la carte électronique 3 n'est pas complètement entrée dans le logement 25 du châssis 2 et n'a pas dépassé le rebord 21, il vaut mieux empêcher la translation verticale vers le bas de la carte électronique 3 laquelle pourrait entraîner la détérioration de sa portion mâle 30 par choc contre le rebord 21. A l'arrière dans le châssis 2 se trouve un taquet 24 destiné à déverrouiller le système de verrouillage 5. Au fond du châssis 2, fixé sur la carte mère électronique 22, se trouve un connecteur femelle 6 dans lequel la portion mâle 30 de la carte électronique 3 est enfichable.

La figure 4 représente schématiquement un exemple d'une deuxième phase d'enfichage vertical de la carte électronique d'un module électronique dans le connecteur d'un châssis d'armoire électrique selon un mode de réalisation de l'invention. De la figure 3 à la figure 4, la course de déplacement de la poignée 41 par sa rotation est très supérieure à la course de déplacement de la carte électronique 3 par sa translation verticale vers le bas.

Le système de verrouillage 5 a été déverrouillé par le taquet 24 en bout de course. En effet, la pointe biseautée 51 du système de verrouillage 5 a glissé sur le taquet biseauté 24 de manière à abaisser la tige 50 de sorte que la protubérance 32 ne soit plus bloquée par la tige 50 mais puisse au contraire traverser la tige 50, c'est-à-dire passer dans un orifice de la tige 50 maintenant en face de la protubérance 32. La tige 50 était maintenue vers le haut par un ressort 52 poussant vers le haut. Le ressort 52 a tendance à tourner dans le sens des aiguilles d'une montre autour de l'axe 53, poussant ainsi la tige 50 vers le haut.

Ce déplacement de la protubérance 32 libère la mobilité en translation verticale de la carte électronique 3. Ainsi, l'opérateur peut descendre le levier 4 en position abaissée contre la grille 12 du module électronique 1, en exerçant une pression manuelle sur la poignée 41, amenant l'ergot 43 à s'encliqueter dans un trou de la grille 12, ce qui bloque le levier 4 en position abaissée. L'abaissement du levier 4 a provoqué et entraîné directement et mécaniquement la translation verticale vers le bas de la carte électronique 3 par rapport au boîtier 10, permettant l'enfichage de sa portion mâle 30 dans le connecteur femelle 6.

La figure 5 représente schématiquement un exemple d'une phase d'extraction verticale de la carte électronique d'un module électronique hors du connecteur d'un châssis d'armoire électrique selon un mode de réalisation de l'invention. Pour extraire la carte électronique 3 du connecteur 6, l'opérateur commence par abaisser la pièce élastique 42 de manière à libérer l'ergot 43 de la grille 12. Ensuite, l'opérateur relève le levier 4 en le faisant pivoter dans le sens des aiguilles d'une montre. La rotation du levier 4 entraîne d'une part l'extraction de la portion mâle 30 de la carte électronique 3 hors du connecteur femelle 6, et d'autre part l'extraction de la protubérance 32 hors de l'orifice de la tige 50.

Ainsi, dès que la translation horizontale vers l'extérieur du châssis 2 va commencer, c'est-à-dire vers la gauche sur la figure 5, la pointe biseautée 51 de la tige 50 va s'écarter du taquet biseauté 24 et la tige 50, qui ne sera alors plus retenue par la protubérance 32, va remonter sous l'effet de la pression du ressort 52. La tige 50 remontée, son orifice ne sera plus en face de la protubérance 32, et le levier 4 va donc rester bloqué en position relevée. Il ne reste plus alors à l'opérateur qu'à continuer la translation horizontale de l'ensemble du module électronique 1 vers l'extérieur du châssis 2, jusqu'à retirer complètement le module électronique 1 du châssis 2. Les opérations de maintenance pourront alors aisément être réalisées sur le module électronique 1, complètement séparé du châssis 2.

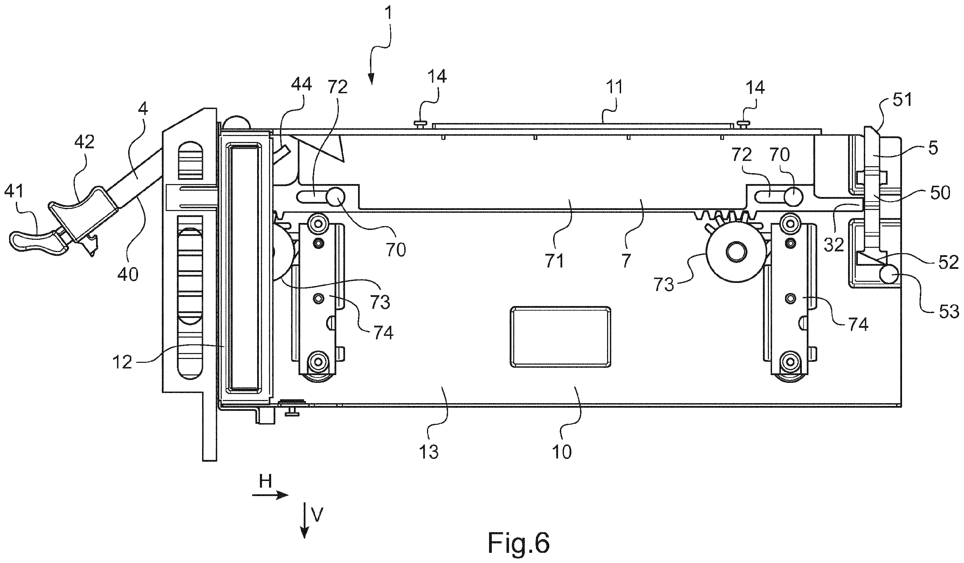

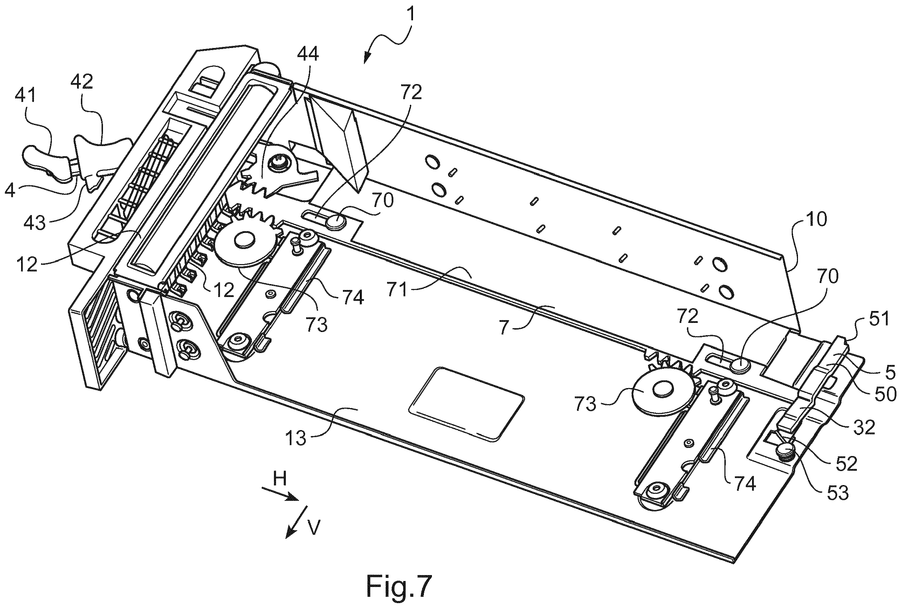

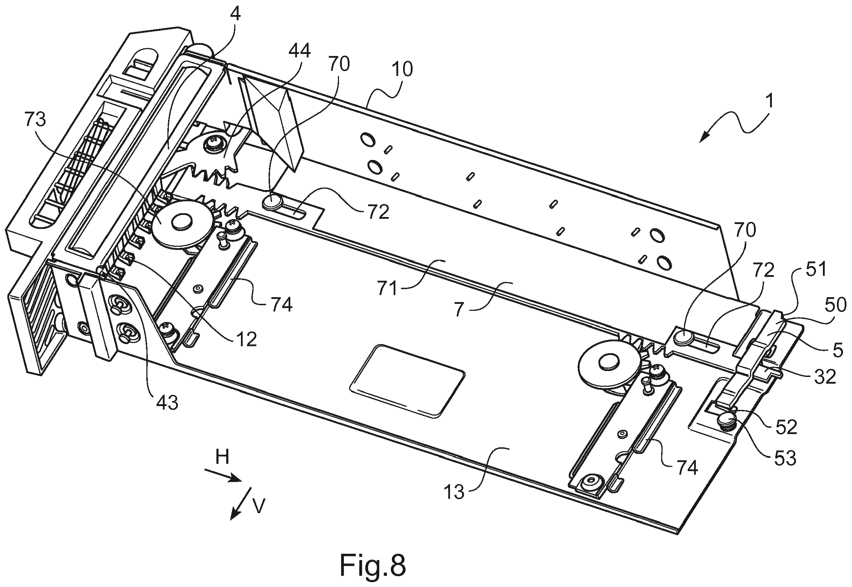

La figure 6 représente schématiquement une vue de côté d'un exemple de boîtier d'un module électronique selon un premier mode de réalisation de l'invention, un peu avant la fin de la phase de translation horizontale. La figure 7 représente schématiquement une vue en perspective d'un exemple de boîtier d'un module électronique selon un premier mode de réalisation de l'invention, un peu avant la fin de la phase de translation horizontale. La figure 8 représente schématiquement une vue en perspective d'un exemple de boîtier d'un module électronique selon un premier mode de réalisation de l'invention, à la fin de la phase de translation horizontale.

Un système de démultiplication 7 d'effort permet de démultiplier l'effort de l'opérateur sur le levier 4 pour exercer une force bien supérieure d'enfichage de la carte électronique 3 dans le connecteur 6, tout en transformant la rotation du levier 4 dans le sens inverse des aiguilles d'une montre en une translation verticale vers le bas de la carte électronique 3 par rapport au boîtier 10. Pour des raisons de clarté, la carte électronique 3 n'est pas représentée mais elle est fixée sur les tiges mobiles verticalement 74. Le système de démultiplication 7 d'effort est un système à crémaillère qui inclut une tige mobile horizontalement 71, deux tiges mobiles verticalement 74, deux roues dentées 73 reliant respectivement la tige mobile horizontalement 71 aux tiges mobiles verticalement 74, de manière à transmettre le mouvement de la tige mobile horizontalement 71 aux tiges mobiles verticalement 74. Des pions 70, solidaires de la paroi du boîtier 10, coopèrent avec des lumières 72 incluses dans la tige mobile horizontalement 71, lors de la translation horizontale de la tige mobile horizontalement 71.

Le fonctionnement est le suivant en partant des figures 6 et 7 pour arriver à la figure 8. Lorsque l'opérateur abaisse le levier 4 en le faisant pivoter dans le sens inverse des aiguilles d'une montre jusqu'à la verticale, l'ergot 43 s'encliquette dans un trou de la grille 12, maintenant bloqué le levier 4 en position abaissée. Ce pivotement du levier 4, dans le sens inverse des aiguilles d'une montre, entraîne la rotation dans le même sens de la roue dentée 44 située à l'extrémité du bras 40. La rotation de la roue dentée 44 dans le sens inverse des aiguilles d'une montre entraîne une translation horizontale de la tige mobile horizontalement 71 vers l'intérieur du châssis 2 non représenté (c'est-à-dire vers la droite des figures 6 et 7). Le déplacement relatif des pions 70 par rapport aux lumières 72 s'effectue de droite à gauche ; en fait, les pions 70 sont fixes par rapport au boîtier 10, tandis les lumières 72 se déplacent avec la tige mobile horizontalement 71. La translation horizontale de la tige mobile horizontalement 71 vers la droite entraîne la rotation conjointe des roues dentées 73 dans le sens des aiguilles d'une montre, laquelle entraîne à son tour la translation verticale conjointe des tiges mobiles verticalement 74 vers le bas, ce qui entraîne la translation verticale vers le bas de la carte électronique 3 aboutissant à son enfichage dans le connecteur 6.

Inversement, le fonctionnement est le suivant en partant de la figure 8 pour arriver aux figures 6 et 7. Lorsque l'opérateur relève la pièce élastique 42 le long du bras 40, l'ergot 43 est libéré de la grille 12 et l'opérateur peut ensuite relever le levier 4 en le faisant pivoter dans le sens des aiguilles d'une montre jusqu'à la position relevée du levier 4. Ce pivotement du levier 4, dans le sens des aiguilles d'une montre, entraîne la rotation dans le même sens de la roue dentée 44 située à l'extrémité du bras 40. La rotation de la roue dentée 44 dans le sens des aiguilles d'une montre entraîne une translation horizontale de la tige mobile horizontalement 71 vers l'extérieur du châssis 2 non représenté (c'est-à-dire vers la gauche de la figure 8).

Le déplacement relatif des pions 70 par rapport aux lumières 72 s'effectue de gauche à droite ; en fait, les pions 70 sont fixes par rapport au boîtier 10, tandis les lumières 72 se déplacent avec la tige mobile horizontalement 71. La translation horizontale de la tige mobile horizontalement 71 vers la gauche entraîne la rotation conjointe des roues dentées 73 dans le sens inverse des aiguilles d'une montre, laquelle entraîne à son tour la translation verticale conjointe des tiges mobiles verticalement 74 vers le haut, ce qui entraîne la translation verticale vers le haut de la carte électronique 3 aboutissant à son extraction hors du connecteur 6.

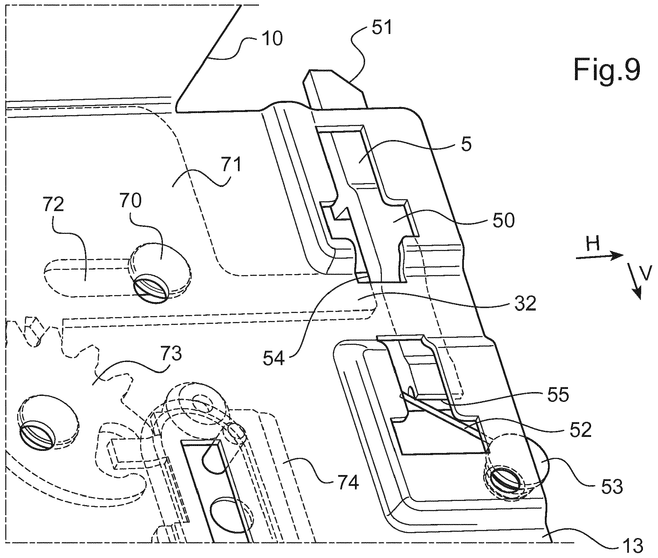

La figure 9 représente schématiquement un détail du système de verrouillage bloquant la translation verticale d'enfichage pour un module électronique selon un premier mode de réalisation de l'invention. L'orifice 54 de la tige 50 dans lequel l'extrémité de la protubérance 32 peut venir se glisser lorsqu'elle est en face, est bien visible. De même pour la rainure 55 de la tige 50 dans laquelle le ressort 52 vient se loger pour pousser la tige 50 vers le haut.

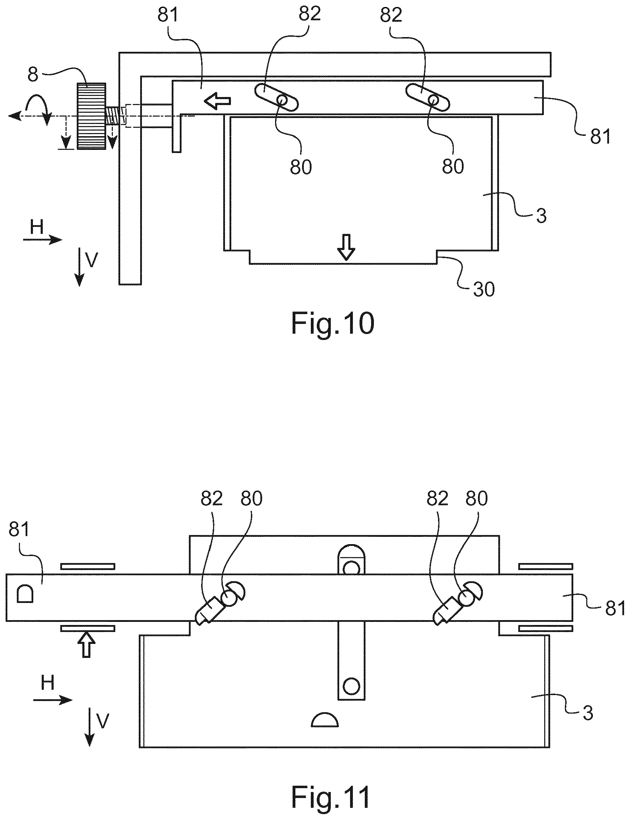

La figure 10 représente schématiquement une vue de côté d'un exemple de module électronique selon une première variante d'un deuxième mode de réalisation de l'invention. Ici, la carte électronique 3 est solidaire d'une barre 81 qui inclut des lumières 82 dans lesquelles glissent des pions 80 solidaires du boîtier 10. La disposition oblique des lumières 82 permet de transformer la translation horizontale de la barre 81 en une translation verticale de la carte électronique 3. Un angle inférieur à 45 degrés, de préférence compris entre 10 et 30 degrés, et encore plus de préférence autour de 20 degrés, de l'axe des lumières 82 par rapport à l'horizontale, permet aussi de démultiplier l'effort de translation horizontale en une force d'enfichage verticale plus grande, mais dans une proportion moindre que pour le premier mode de réalisation. Ici, la translation horizontale de la barre 81 entraîne directement et simultanément la translation verticale de la carte électronique 3. La translation horizontale de la barre 81 est réalisée à l'aide d'un moteur 8 dont la rotation entraîne celle d'une vis sans fin poussant ou tirant horizontalement la barre 81.

La figure 11 représente schématiquement une vue de côté d'un exemple de module électronique selon une deuxième variante d'un deuxième mode de réalisation de l'invention. La translation horizontale de la barre 81 est ici réalisée manuellement, l'opérateur poussant ou tirant horizontalement la barre 81 directement.

Bien entendu, la présente invention n'est pas limitée aux exemples et au mode de réalisation décrits et représentés, mais elle est susceptible de nombreuses variantes accessibles à l'homme de l'art.

## Revendications

1. Procédé d'enfichage, dans un connecteur (6) d'un châssis (2), d'une carte électronique (3) logée dans un boîtier (10) d'un module électronique (1), comprenant:
- une translation rectiligne dudit module (1), par rapport audit châssis (2), selon une première direction (H), de manière à rentrer ledit module (1) dans ledit châssis (2), et ensuite,
- une translation rectiligne de ladite carte (3), par rapport audit châssis (2), selon une deuxième direction (V) différente de ladite première direction (H), de manière à enficher ladite carte (3) dans ledit connecteur (6),
- ladite translation rectiligne, selon ladite deuxième direction (V), de ladite carte (3), par rapport audit châssis (2), étant également une translation rectiligne, selon ladite deuxième direction (V), de ladite carte (3), par rapport audit boîtier (10) dudit module (1),
ladite translation rectiligne, selon ladite deuxième direction (V), de ladite carte (3), par rapport audit châssis (2) étant provoquée et entrainée par un déplacement d'un actionneur mécanique, la course dudit déplacement dudit actionneur mécanique (4) étant supérieure à la course de ladite translation rectiligne selon ladite deuxième direction (V) de manière à enficher ladite carte (3) dans ledit connecteur (6), de sorte que le premier effort dudit déplacement dudit actionneur mécanique (4) soit plus faible que le deuxième effort de ladite translation rectiligne selon ladite deuxième direction (V) de manière à enficher ladite carte (3) dans ledit connecteur (6), un système de démultiplication (7) d'effort reliant ledit actionneur (4) à ladite carte (3), ledit système de démultiplication comprenant un système à crémaillère (7) incluant une tige mobile (71) selon la première direction (H), au moins une tige mobile (74) selon la deuxième direction (V), de préférence deux tiges mobiles (74) selon la deuxième direction (V), et au moins une roue dentée (73) reliant la tige mobile (71) selon la première direction (H) à une tige mobile (74) selon la deuxième direction (V), de manière à transmettre le mouvement de la tige mobile (71) selon la première direction (H) à au moins une tige mobile (74) selon la deuxième direction (V).

2. Procédé d'enfichage selon la revendication 1, **caractérisé en ce que** le système de démultiplication (7) d'effort reliant ledit actionneur (4) à ladite carte (3) de sorte que ledit premier effort soit au moins deux fois plus faible que ledit deuxième effort, de préférence de sorte que ledit premier effort soit au moins cinq fois plus faible que ledit deuxième effort.

3. Procédé d'enfichage selon l'une quelconque des revendications 1 ou 2, **caractérisé en ce que** l'actionneur (4) est actionné manuellement.

4. Procédé d'enfichage selon l'une quelconque des revendications 1 à 3, **caractérisé en ce que** l'actionneur (4) est un levier mobile en rotation.

5. Procédé d'enfichage selon l'une quelconque des revendications précédentes, **caractérisé en ce qu'**un système de verrouillage (5) est disposé de manière à n'autoriser ladite translation selon la deuxième direction (V) qu'après la fin de ladite translation selon la première direction (H).

6. Procédé d'enfichage selon l'une quelconque des revendications précédentes, **caractérisé en ce que** la deuxième direction (V) est perpendiculaire à la première direction (H).

7. Procédé d'enfichage selon l'une quelconque des revendications précédentes, **caractérisé en ce que**, lors de ladite translation selon la deuxième direction (V), ladite carte (3) est guidée par ledit boîtier (10) dudit module (1), ledit boîtier (10) dudit module (1) restant immobile en translation selon la deuxième direction (V) par rapport au châssis (2).

8. Système d'enfichage, dans un connecteur (6) d'un châssis (2), d'une carte électronique (3) logée dans un boîtier (10) d'un module électronique (1), comprenant:
- un système de translation rectiligne dudit module (1), par rapport audit châssis (2), selon une première direction (H), de manière à rentrer ledit module (1) dans ledit châssis (2),
- un système de translation rectiligne de ladite carte (3), par rapport audit châssis (2), selon une deuxième direction (V) différente de ladite première direction (H), de manière à enficher ladite carte (3) dans ledit connecteur (6),
- ledit système de translation rectiligne, selon ladite deuxième direction (V), de ladite carte (3), par rapport audit châssis (2), étant également un système de translation rectiligne, selon ladite deuxième direction (V), de ladite carte (3), par rapport audit boîtier (10) dudit module (1),
ledit système de translation rectiligne, selon la deuxième direction (V), de ladite carte (3), par rapport audit châssis (2), étant actionné par un actionneur mécanique (4) actionnable manuellement, un système de démultiplication (7) d'effort reliant ledit actionneur (4) à ladite carte (3) de sorte à multiplier l'effort manuel d'actionnement dudit actionneur (4) pour augmenter la force d'enfichage, ledit système de démultiplication comprenant un système à crémaillère incluant une tige mobile (71) selon la première direction (H), au moins une tige mobile (74) selon la deuxième direction (V), de préférence deux tiges mobiles (74) selon la deuxième direction (V), et au moins une roue dentée (73) reliant la tige mobile (71) selon la première direction (H) à une tige mobile (74) selon la deuxième direction (V), de manière à transmettre le mouvement de la tige mobile (71) selon la première direction (H) à au moins une tige mobile (74) selon la deuxième direction (V).

9. Module électronique comportant un boîtier (10), une carte électronique (3) qui est logée dans ledit boîtier (10) dudit module électronique (1) et qui est destinée à être enfichée dans un connecteur (6) d'un châssis (2), **caractérisé en ce qu'**il comprend aussi un système de translation rectiligne de ladite carte (3) par rapport audit boîtier (10), ledit système de translation rectiligne étant disposé de manière à faciliter l'enfichage de ladite carte (3) dans un connecteur (6) de châssis (2), ledit système de translation rectiligne étant actionné par un actionneur mécanique (4) actionnable manuellement, et un système de démultiplication (7) d'effort reliant ledit actionneur (4) à ladite carte (3) de sorte à démultiplier l'effort manuel d'actionnement dudit actionneur (4) pour augmenter la force d'enfichage, ledit système de démultiplication comprenant un système à crémaillère incluant une tige mobile (71) selon la première direction (H), au moins une tige mobile (74) selon la deuxième direction (V), de préférence deux tiges mobiles (74) selon la deuxième direction (V), et au moins une roue dentée (73) reliant la tige mobile (71) selon la première direction (H) à une tige mobile (74) selon la deuxième direction (V), de manière à transmettre le mouvement de la tige mobile (71) selon la première direction (H) à au moins une tige mobile (74) selon la deuxième direction (V).

## Patentansprüche

1. Verfahren zum Einstecken einer in einem Gehäuse (10) eines elektronischen Moduls (1) aufgenommenen Leiterplatte (3) in einen Steckverbinder (6) eines Rahmens (2), umfassend:
- geradliniges Verschieben des Moduls (1) bezüglich des Rahmens (2) in einer ersten Richtung (H), so dass das Modul (1) in den Rahmen (2) eingeführt wird, dann
- geradliniges Verschieben der Leiterplatte (3) bezüglich des Rahmens (2) in einer zweiten Richtung (V), die sich von der ersten Richtung (H) unterscheidet, so dass die Leiterplatte (3) in den Steckverbinder (6) eingesteckt wird,
- wobei das geradlinige Verschieben der Leiterplatte (3) bezüglich des Rahmens (2) in der zweiten Richtung (V) auch ein geradliniges Verschieben der Leiterplatte (3) bezüglich des Gehäuses (10) des Moduls (1) in der zweiten Richtung (V) ist,
wobei das geradlinige Verschieben der Leiterplatte (3) bezüglich des Rahmens (2) in der zweiten Richtung (V) durch Verlagerung eines mechanischen Betätigungsglieds ausgelöst und durchgeführt wird, wobei die Wegstrecke der Verlagerung des mechanischen Betätigungsglieds (4) größer als die Wegstrecke der geradlinigen Verschiebung in der zweiten Richtung (V) ist, um die Leiterplatte (3) in den Steckverbinder (6) einzustecken, derart, dass der erste Kraftaufwand bei der Verlagerung des mechanischen Betätigungsglieds (4) geringer als der zweite Kraftaufwand bei dem geradlinigen Verschieben in der zweiten Richtung (V) ist, um die Leiterplatte (3) in den Steckverbinder einzustecken, wobei ein Kraftuntersetzungssystem (7) das Betätigungsglied (4) mit der Leiterplatte (3) verbindet, wobei das Untersetzungssystem ein Zahnstangensystem (7) mit einer in der ersten Richtung (H) beweglichen Stange (71), zumindest einer in der zweiten Richtung (V) beweglichen Stange (74), vorzugsweise zwei in der zweiten Richtung (V) beweglichen Stangen (74), und zumindest ein Zahnrad (73) enthält, das die in der ersten Richtung (H) bewegliche Stange (71) mit einer in der zweiten Richtung (V) beweglichen Stange so verbindet, dass die Bewegung der in der ersten Richtung (H) beweglichen Stange auf zumindest eine in der zweiten Richtung (V) beweglichen Stange (74) übertragen wird.

2. Einsteckverfahren nach Anspruch 1, **dadurch gekennzeichnet, dass** das Kraftuntersetzungssystem (7) das Betätigungsglied (4) mit der Leiterplatte (3) so verbindet, dass der erste Kraftaufwand zumindest zweimal niedriger ist als der zweite Kraftaufwand, vorzugsweise dass der erste Kraftaufwand zumindest fünfmal niedriger ist als der zweite Kraftaufwand.

3. Einsteckverfahren nach einem der Ansprüche 1 oder 2, **dadurch gekennzeichnet, dass** das Betätigungsglied (4) manuell betätigt wird.

4. Einsteckverfahren nach einem der Ansprüche 1 bis 3, **dadurch gekennzeichnet, dass** das Betätigungsglied (4) ein drehbarer Hebel ist.

5. Einsteckverfahren nach einem der vorangehenden Ansprüche, **dadurch gekennzeichnet, dass** ein Verriegelungssystem (5) so angeordnet ist, dass es die Verschiebung in der zweiten Richtung (V) erst nach Beendigung der Verschiebung in der ersten Richtung (H) gestattet.

6. Einsteckverfahren nach einem der vorangehenden Ansprüche, **dadurch gekennzeichnet, dass** die zweite Richtung (V) senkrecht zur ersten Richtung (H) verläuft.

7. Einsteckverfahren nach einem der vorangehenden Ansprüche, **dadurch gekennzeichnet, dass** bei der Verschiebung in der zweiten Richtung (V) die Leiterplatte (3) über das Gehäuse (10) des Moduls (1) geführt wird, wobei das Gehäuse (10) des Moduls (1) angesichts der Verschiebung bezüglich des Rahmens (2) in der zweiten Richtung (V) stillsteht.

8. Einstecksystem zum Einstecken einer in einem Gehäuse (10) eines elektronischen Moduls (1) aufgenommenen Leiterplatte (3) in einen Steckverbinder (6) eines Rahmens (2), enthaltend:
- ein System zum geradlinigen Verschieben des Moduls (1) bezüglich des Rahmens (2) in einer ersten Richtung (H), so dass das Modul (1) in den Rahmen (2) eingeführt wird,
- ein System zum geradlinigen Verschieben der Leiterplatte (3) bezüglich des Rahmens (2) in einer zweiten Richtung (V), die sich von der ersten Richtung (H) unterscheidet, so dass die Leiterplatte (3) in den Steckverbinder (6) eingesteckt wird,
- wobei das System zum geradlinigen Verschieben der Leiterplatte (3) bezüglich des Rahmens (2) in der zweiten Richtung (V) auch ein System zum geradlinigen Verschieben der Leiterplatte (3) bezüglich des Gehäuses (10) des Moduls (1) in der zweiten Richtung (V) ist,
wobei das System zum geradlinigen Verschieben der Leiterplatte (3) bezüglich des Rahmens (2) in der zweiten Richtung (V) über ein manuell betätigbares, mechanisches Betätigungsglied (4) betätigt wird, wobei ein Kraftuntersetzungssystem (7) das Betätigungsglied (4) mit der Leiterplatte (3) so verbindet, dass der manuelle Kraftaufwand zum Betätigen des Betätigungsglieds (4) verstärkt wird, um die Einsteckkraft zu erhöhen, wobei das Untersetzungssystem ein Zahnstangensystem (7) mit einer in der ersten Richtung (H) beweglichen Stange (71), zumindest einer in der zweiten Richtung (V) beweglichen Stange (74), vorzugsweise zwei in der zweiten Richtung (V) beweglichen Stangen (74), und zumindest ein Zahnrad (73) enthält, das die in der ersten Richtung (H) bewegliche Stange (71) mit einer in der zweiten Richtung (V) beweglichen Stange (74) so verbindet, dass die Bewegung der in der ersten Richtung (H) beweglichen Stange (71) zumindest auf eine in der zweiten Richtung (V) beweglichen Stange (74) übertragen wird.

9. Elektronisches Modul, enthaltend ein Gehäuse (10), eine in dem Gehäuse (10) des elektronischen Moduls (1) aufgenommene Leiterplatte (3), die dazu bestimmt ist, in einen Steckverbinder (6) eines Rahmens (2) eingesteckt zu werden, **dadurch gekennzeichnet, dass** es auch ein System zum geradlinigen Verschieben der Leiterplatte (3) bezüglich des Gehäuses (10) enthält, wobei das System zum geradlinigen Verschieben so angeordnet ist, dass es das Einstecken der Leiterplatte (3) in einen Steckverbinder (6) des Rahmens (2) erleichtert, wobei das System zum geradlinigen Verschieben über ein manuell betätigbares, mechanisches Betätigungsglied (4) betätigt wird, sowie ein Kraftuntersetzungssystem (7), welches das Betätigungsglied (4) mit der Leiterplatte (3) so verbindet, dass der manuelle Kraftaufwand zum Betätigen des Betätigungsglieds (4) untersetzt wird, um die Einsteckkraft zu erhöhen, wobei das Untersetzungssystem ein Zahnstangensystem mit einer in der ersten Richtung (H) beweglichen Stange (71), zumindest einer in der zweiten Richtung (V) beweglichen Stange (74), vorzugsweise zwei in der zweiten Richtung (V) beweglichen Stangen (74), und zumindest ein Zahnrad (73) enthält, das die in der ersten Richtung (H) bewegliche Stange (71) mit einer in der zweiten Richtung (V) beweglichen Stange (74) so verbindet, dass die Bewegung der in der ersten Richtung (H) beweglichen Stange (71) auf zumindest eine in der zweiten Richtung (V) beweglichen Stange (74) übertragen wird.

## Claims

1. Method for plugging an electronic card (3) housed in a casing (10) of an electronic module (1) into a connector (6) of a chassis (2), comprising:
- rectilinear translation of said module (1) relative to said chassis (2) in a first direction (H) so as to insert said module (1) into said chassis (2), and then
- rectilinear translation of said card (3) relative to said chassis (2) in a second direction (V) different to said first direction (H) so as to plug said card (3) into said connector (6),
- said rectilinear translation of said card (3) relative to said chassis (2) in said second direction (V) also being rectilinear translation of said card (3) relative to said casing (10) of said module (1) in said second direction (V),
said rectilinear translation of said card (3) relative to said chassis (2) in said second direction (V) being caused and driven by displacement of a mechanical actuator, the course of said displacement of said mechanical actuator (4) being greater than the course of said rectilinear translation in said second direction (V) so as to plug said card (3) into said connector (6) so that the first effort of said displacement of said mechanical actuator (4) is weaker than the second effort of said rectilinear translation in said second direction (V) so as to plug said card (3) into the connector (6), an effort reduction system (7) connecting said actuator (4) to said card (3), said reduction system comprising a rack and pinion system (7) including a rod (71) mobile in the first direction (H), at least one rod (74) mobile in the second direction (V), preferably two rods (74) mobile in the second direction (V), and at least one gear wheel (73) connecting the rod (71) mobile in the first direction (H) to a rod (74) mobile in the second direction (V) so as to transmit the movement of the rod (71) mobile in the first direction (H) to at least one rod (74) mobile in the second direction (V).

2. Plugging method according to claim 1, **characterised in that** the effort reduction system (7) connects said actuator (4) to said card (3) so that said first effort is at least two times weaker than said second effort, preferably so that said first effort is at least five times weaker than said second effort.

3. Plugging method according to any one of claims 1 or 2, **characterised in that** the actuator (4) is actuated manually.

4. Plugging method according to any one of claims 1 to 3, **characterised in that** the actuator (4) is a lever mobile in rotation.

5. Plugging method according to any one of the preceding claims, **characterised in that** a locking system (5) is positioned so as to allow said translation in the second direction (V) only after the end of said translation in the first direction (H).

6. Plugging method according to any one of the preceding claims, **characterised in that** the second direction (V) is perpendicular to the first direction (H).

7. Plugging method according to any one of the preceding claims, **characterised in that** during said translation in the second direction (V) said card (3) is guided by said casing (10) of said module (1), said casing (10) of said module (1) remaining immobile in translation in the second direction (V) relative to the chassis (2).

8. System for plugging an electronic card (3) housed in a casing (10) of an electronic module (1) into a connector (6) of a chassis (2), comprising:
- a system for rectilinear translation of said module (1) relative to said chassis (2) in a first direction (H) so as to insert said module (1) into said chassis (2),
- a system for rectilinear translation of said card (3) relative to said chassis (2) in a second direction (V) different to said first direction (H) so as to plug said card (3) into the said connector (6),
- said system for rectilinear translation of said card (3) relative to said chassis (2) in said second direction (V) also being a system for rectilinear translation of said card (3) relative to said casing (10) of said module (1) in said second direction (V),
said system for rectilinear translation of said card (3) relative to said chassis (2) in said second direction (V) being actuated by a mechanical actuator (4) which can be actuated manually, an effort reduction system (7) connecting said actuator (4) to said card (3) so as to multiply the manual actuating effort of said actuator (4) in order to increase the plugging in force, said reduction system comprising a rack and pinion system including a rod (71) mobile in the first direction (H), at least one rod (74) mobile in the second direction (V), preferably two rods (74) mobile in the second direction (V), and at least one gear wheel (73) connecting the rod (71) mobile in the first direction (H) to a rod (74) mobile in the second direction (V) so as to transmit the movement of the rod (71) mobile in the first direction (H) to at least one rod (74) mobile in the second direction (V).

9. Electronic module comprising a casing (10), an electronic card (3) which is housed in said casing (10) of said electronic module (1) and which is designed to be plugged into a connector (6) of a chassis (2), **characterised in that** it also comprises a system for rectilinear translation of said card (3) relative to said casing (10), said system for rectilinear translation being positioned so as to facilitate plugging said card (3) into a connector (6) of a chassis (2), said system for rectilinear translation being actuated by a mechanical actuator (4) which can be actuated manually, and an effort reduction system (7) connecting said actuator (4) to said card (3) so as to reduce the manual actuating effort of said actuator (4) in order to increase the plugging in force, said reduction system comprising a rack and pinion system including a rod (71) mobile in the first direction (H), at least one rod (74) mobile in the second direction (V), preferably two rods (74) mobile in the second direction (V), and at least one gear wheel (73) connecting the rod (71) mobile in the first direction (H) to a rod (74) mobile in the second direction (V), so as to transmit the movement of the rod (71) mobile in the first direction (H) to at least one rod (74) mobile in the second direction (V).
